# EUROPEAN PATENT SPECIFICATION

(11) **EP 1 754 254 B1**
(45) Date of publication and mention of the grant of the patent: **28.05.2008**
(21) Application number: 05742317.0
(22) Date of filing: 26.05.2005
(51) Int. Cl.: H01L 21/68, C23C 16/44

(54) **LIFT PIN WITH ROLLER GLIDE FOR REDUCING FRICTION**
HEBEZAPFEN MIT WALZENSCHIEBER ZUR VERRINGERUNG DER REIBUNG
TIGE DE LEVAGE EQUIPE D'UN PATIN PERMETTANT DE REDUIRE LE FROTTEMENT

(30) Priority: 28.05.2004 US 575158 P
(43) Date of publication of application: 21.02.2007
(73) Proprietor: OC Oerlikon Balzers AG, 9496 Balzers (LI)
(72) Inventor: DUBOST, Laurent, F-91580 Etrechy (FR); HERNANDEZ, Sylvain, F-94190 Villeneuve Saint Georges (FR); JAEGER, Hans, CH-4922 Thunstätten (CH); LANDRY, Karine, F-38100 Grenoble (FR); VINEL, Bertrand, F-15000 Aurillac (FR); ZAPODEANU, Eugène, F-75020 Paris (FR); SCHMITT, Jacques, F-91620 La Ville du Bois (FR); EL BOUCHIKHY, Redouane, F-91600 Savigny sur Orge (FR)
(86) International application number: PCT/CH2005/000299
(87) International publication number: WO 2005/117097

(56) References cited:
- US-A1- 2004 045 509
- US-A1- 2004 051 220

## Description

### Background of the invention

The invention addresses pin systems that are used in vacuum chambers in general and in plasma enhanced chemical vapor deposition (PECVD) reactors in particular. These pins are used for lifting and supporting substrates in a reactor. When the reactor is open, the pins are elevated to receive the substrate, which is introduced by a robot fork. After the substrate has been placed on the pins, they are lowered until the substrate reaches the position in which the substrate is to be treated. There are also systems known in the art, where the reactor bottom is elevated relatively to the pins. The pins run in a guidance hole that is machined into the reactor bottom. Typically, the upper end of the guidance hole that disembogue to the reactor's interior is countersunk. Additionally, the pin head is flared to prevent the pins from falling through the guidance hole. The two latter characteristics of the pin system allow the pin head to be positioned close to flush with the reactor bottom. Usually, an elevator system consisting of a lift-arm and an elevator mechanism lifts the pin in the desired position.

The current pin design, both geometry and materials, suffer from frequent pin self-locking and pin breakage. Both issues result in inhomogeneous deposition rates, substrate fracture and can even lead to a reactor shut-down.

The pin self-locking is due to lateral forces that are applied on the pin. These lateral forces can be induced by the thermal expansion of the substrate when entering the heated chamber and the pin elevation system that pushes the pin not exactly in the guidance hole axis. High friction at the pin-substrate, pin-elevator and pin-guidance interfaces combined with insufficient guidance (poor pin to guide length ratio) amplify the pin-locking issue. The pin breakage can happen when the elevator pushes on a self-locked pin.

### Description of related art

US 2004/0045509 teach how to reduce the friction between the pin and its guidance hole. The solution is based on a pin design, where the pin has at least one larger diameter shoulder that reduces the contact area between the pin and its guidance hole, thereby reducing pin scratching, particle generation and component wear.

Another attempt to reducing the lateral forces that act on the pin is described in US application 2003/0205329. Herein, a pin design is presented that decouples the lateral forces that are induced by a lift-arm. The pin system consists mainly of three parts; a lifting pin, an actuator pin and a lift arm. The lifting pin and the actuator pin are each guided in two bushings. The two pins are coaxial positioned in such a way that the actuator pin is used to move the lifting pin in the upper and lower end positions. A connector acts as an interface between the said pins. This connector allows for lateral clearance between the actuator pin and the lift pin. The actuator pin itself is moved by a lift-arm assembly that houses wear pads. The actuator pins are disposed on these wear pads that are larger in diameter as the actuator pin. The actuator pins may float laterally across the wear pads.

The solutions presented in US 2004/0045509 and 2003/0205329 only partially solve the aforementioned technical problems. The first is designed to reduce the friction in the pin movement direction and the second is designed to reduce lateral forces on the pin systems that are induced by the elevator system.

Prior art does not provide a solution that reduces the friction between the pin system and its guidance hole and the lateral forces that are induced by the elevator at the same time. Additionally, there is no known solution that decouples the lateral forces that are induced by the substrate.

### Summary of the invention

The present invention aims at reducing the lateral forces that are acting on the pin and the guidance friction during the elevation movement. Lateral forces can be induced by the lift-arm and the substrate. The elevator system consists of an lift-arm and a sole plate that is attached to the arm. The pin stands loose on the sole plate and resides in a bushing that is mounted on the reactor bottom. Therefore, the contact areas pin/substrate, pin/sole plate and pin/bushing are of primary interest.

An inventive pin assembly for lifting and supporting substrates therefore comprises a lift pin (1) having a top and a bottom end; the top end being construed to receive and support a substrate (4); the bottom end being construed to be actuated by an elevator system (3a); the lift pin being movably sustained by a guide, wherein said guide comprises a roller glide to reduce the friction of the pin movement in a vertical axis. In further embodiments the roller glide comprises six rollers, arranged in a bushing and is being mounted on the reactor bottom. Furtheron the bottom end of the lift pin (1) is, at least during the lifting operation, in contact with the the elevator system via a sole plate, comprising a top plate (7) being laterally movable relative to said elevator system. The sole plate further comprises a ball holding plate (8) with balls (9) being arranged beyond the top plate (7), which again may be laterally movable relative to said elevator system. In a further aspect of the invention the top end of the lift pin (1) further comprises a clearance being construed to hold a rolling ball (14) being supported by a ball bearing (13) and secured by a retaining ring.

### Brief description of the drawings

Fig. 1a) shows an inventive support and lifting device employing three aspects of the invention.
Fig. 1b) shows a substrate on said inventive device in a bottom position
Fig. 1c) shows a substrate on said inventive device in a top position
Fig. 2 shows a cross section through and a top view on a roller bearing bushing according to one aspect of the invention
Fig. 3 shows ball bearing sole plate according to a further aspect of the invention
Fig. 4 shows a ball bearing head according to a further aspect of the invention.

### Detailed description of the invention

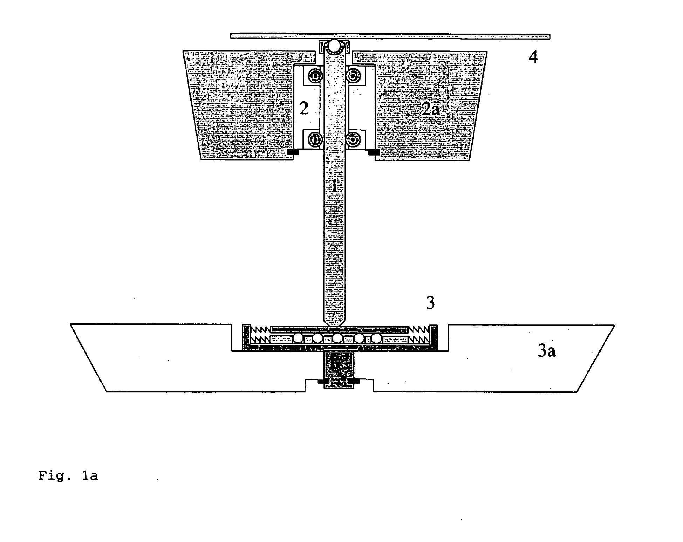

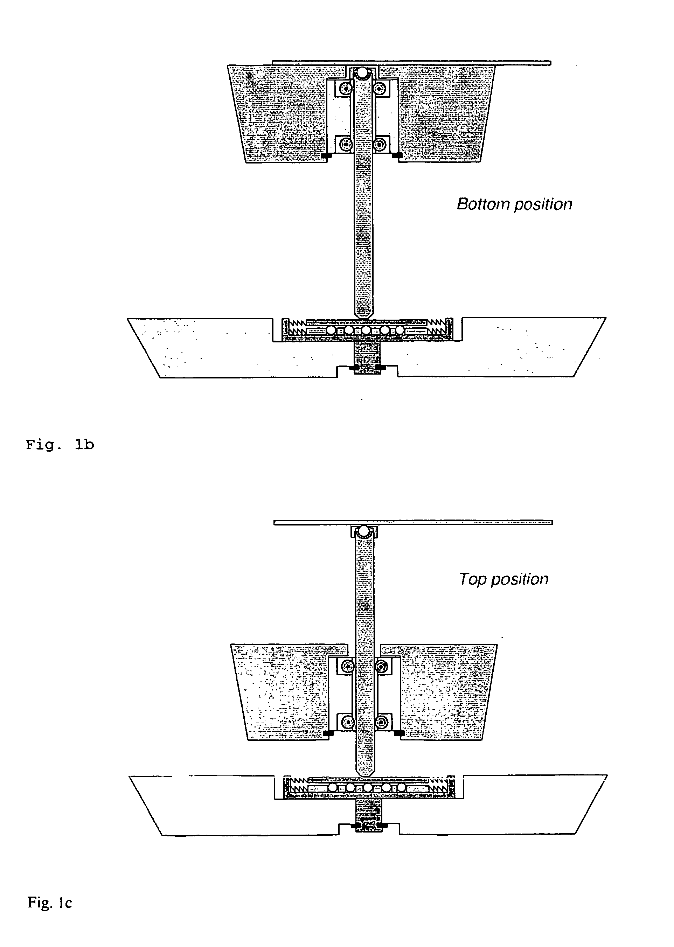

Figure 1a shows the assembly of a pin system: A pin 1 is guided by the roller glide 2 and is actuated by the sole plate 3, which is mounted to a lift-arm 3a. At least three of these pin systems are applied for supporting and lifting a substrate 4. The pins are supposed to receive the substrate 4 from a robot fork (not shown in Figure 1) that places the substrate on the elevating pins. Then, the pins pose the substrate 4 on the reactor bottom 2a (Fig. 1b). This is the substrate's final position before the coating process starts. After the coating process has ended, the pins lift the substrate in the elevated position (Fig. 1 c) before a robot fork removes the substrate from the coating chamber.

The inventive pin system comprises three elements: a roller glide, a ball bearing sole plate and a ball-bearing head pin.

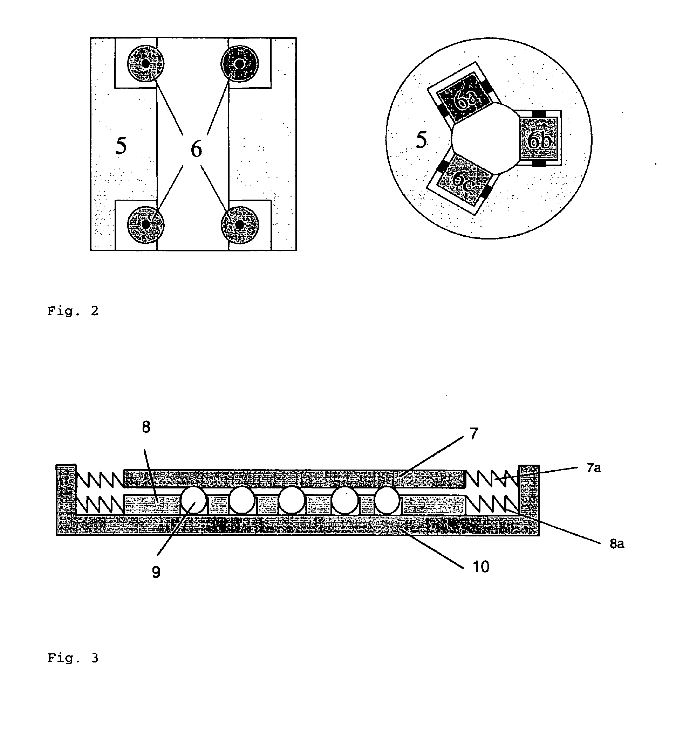

The first of the presented elements is the roller glide 2. This roller glide is designed for reducing the friction of the pin movement in a vertical axis. The roller glide is mounted on the reactor bottom 2a and guides the pin. The glide (see Fig. 2) consists of e. g. six rollers 6, 6 a, b, c that are made out of a material allowing low friction and low wear with the axis and bushing, chemically resistant against the process gases, and which keeps its properties at the process temperature. The rollers itself are held by bushing (5) made of such a material.

A second element defines the interface between the pin and the elevator (see Fig. 3) : A ball bearing sole plate. This sole plate minimizes the lateral forces that could act on the pin. The lateral forces are induced by the lift-arm due to its lifting movement that does not match perfectly the pin's vertical movement axis. The sole plate comprises four main elements: the top plate 7 and the ball holding plate 8 that are elastically borne on the bottom plate 10. Balls 9 improve the top plate's lateral freedom of movement and hence minimize the lateral forces that act on the pin. The elastic bearing 7a, 8a of the top plate 7 and the ball holding plate 8 is needed for re-centering said two plates after one pin moving cycle. The restoring force of the elastic bearing, e. g. a spring is a limiting factor for the lateral force that can be transmitted on the pin. Therefore, the spring constant should be relatively low to permit the floating movement of the top plate 7.

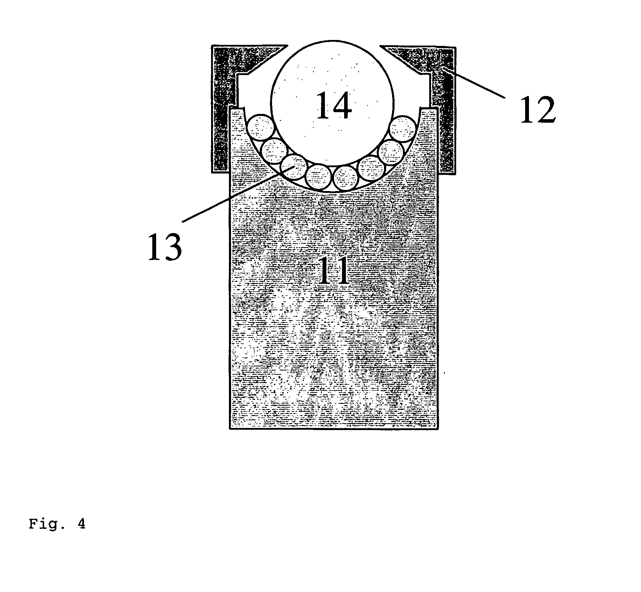

The third element according to the invention is a pin ball-bearing head. (Fig. 4) The function of this modified pin head is to reduce the lateral forces that act on the pin. These forces may be introduced by the substrate. The pin head consists of a pin end 11 with a hemispherical clearance and a retaining ring 12, which holds a ball bearing 13 and a rolling ball 14. The rotational freedom of movement of the rolling ball 14 is enhanced by the ball bearing 13. Thereby, the lateral forces that can be induced by the substrate are minimized. The retaining ring (12) is slightly thicker than the pin shaft in order to prevent the pin from falling through the roller glide.

### Advantages of the invention

The inventive pin design lowers the risk of self-locking considerably. The features of the new solution, less guiding friction paired with decoupling of lateral forces, lead to a higher yield ratio and less downtime of the coating device. Additional positive effects are the reduction of particles in the reactor and the reduction of the risk to scratch the substrate. Thanks to the reduced friction of the pins, the abrasive forces between the pins and its guidance, as well as between the pins and the substrate are minimized. Particle contamination and the risk to scratch the substrate of the reactor are lowered.

All these new characteristics increase the productivity and the quality of the coating process and hence increase the economic value to the user of such devices.

### List of numerals:

- 1: pin, lift pin
- 2: roller glide
- 2a: reactor bottom
- 3: plate
- 3a: lift arm, elevator system
- 4: substrate
- 5: bushing
- 6: roller
- 6a, b, c: roller
- 7: top plate
- 7a: elastic bearing
- 8: ball holding plate
- 8a: elastic bearing
- 9: ball(s)
- 10: bottom plate
- 11: pin end
- 12: retaining ring
- 13: ball bearing
- 14: rolling ball

## Claims

1. Pin assembly for lifting and supporting substrates comprising:
- A lift pin (1) having a top and a bottom end;
- the top end being construed to receive and support a substrate (4);
- the bottom end being construed to be actuated by an elevator system (3a);
- the lift pin (1) being movably sustained by a guide,
wherein said guide comprises a roller glide (2) to reduce the friction of the pin movement in a vertical axis.

2. Pin assembly according to claim 1, wherein the roller glide comprises six rollers (6) arranged in a bushing (5).

3. Pin assembly according to claims 1 or 2, wherein the roller glide (2) is being mounted on a reactor bottom (2a).

4. Pin assembly according to claims 1 to 3, wherein the roller glide (2) comprises rollers (6) made from material allowing low wear and low friction.

5. Pin assembly according to claim 2, wherein the roller glide (2) and the bushing (5) are made of the same material.

6. Pin assembly according to claim 1, wherein the bottom end of the lift pin (1) is, at least during the lifting operation, in contact with an elevator system (3a) via a sole plate (3).

7. Pin assembly according to claim 6, wherein the sole plate (3) comprises a top plate (7) being laterally movable relative to said elevator system (3a).

8. Pin Assembly according to claim 6 or 7, wherein the sole plate (3) further comprises a ball holding plate (8) with balls (9) being arranged beyond the top plate (7).

9. Pin assembly according to claims 8, wherein the ball holding plate (8) is laterally movable relative to said elevator system.

10. Pin assembly according to claims 7 or 9, wherein the lateral movement of top plate (7) and holding plate (8) is facilitated by elastic bearings (7a, 8a).

11. Pin assembly according to claim 1, wherein the top end of the lift pin (1) further comprises a clearance being construed to hold a rolling ball (14).

12. Pin assembly according to claim 11, wherein the rolling ball (14) is supported by a ball bearing (13).

13. Pin assembly according to claim 11 or 12, further with a retaining ring (12) partially covering the clearance and preventing the lift pin from falling through the roller glide.

## Patentansprüche

1. Zapfenanordnung zum Heben und Halten von Substraten, aufweisend:
- einen Hebezapfen (1) mit einem oberen und einem unteren Ende;
- wobei das obere Ende dazu eingerichtet ist ein Substrat (4) aufzunehmen und zu halten;
- wobei das untere Ende dazu eingerichtet ist, von einem Hebesystem (3a) betätigt zu werden;
- wobei der Hebezapfen (1) von einer Führung beweglich gehalten wird,
wobei diese Führung eine Rollenführung (2) aufweist um die Reibung der Zapfenbewegung in einer vertikalen Achse zu verringern.

2. Zapfenanordnung nach Anspruch 1, wobei die Kugelführung sechs Kugeln (6) aufweist die in einer Buchse (5) angeordnet sind.

3. Zapfenanordnung gemäß Anspruch 1 oder 2, wobei die Rollenführung (2) auf einem Boden der Reaktionsanlage (2a) befestigt ist.

4. Zapfenanordnung nach den Ansprüchen 1 bis 3, wobei die Rollenführung (2) Rollen (6) aufweist, die aus einem Werkstoff bestehen, der wenig Verschleiß und wenig Reibung aufweist.

5. Zapfenanordnung nach Anspruch 2, wobei die Rollenführung (2) und die Buchse (5) aus dem gleichen Material hergestellt sind.

6. Zapfenanordnung nach Anspruch 1, wobei sich das untere Ende des Hebezapfens (1) zumindest während des Hebebetriebs durch eine Bodenplatte (3) in Berührung mit dem Hebesystem (3a) befindet.

7. Zapfenanordnung nach Anspruch 6, wobei die Bodenplatte (3) eine obere Platte (7) aufweist, die in Bezug auf das Hebesystem (3a) seitwärts bewegt werden kann.

8. Zapfenanordnung nach Anspruch 6 oder 7, wobei die Bodenplatte (3) weiterhin eine Kugelhalteplatte (8) aufweist, die Kugeln (9) aufweist, welche unter der oberen Platte (7) angeordnet sind.

9. Zapfenanordnung nach Anspruch 8, wobei die Kugelhalteplatte (8) in Bezug auf dieses Hebesystem seitwärts beweglich ist.

10. Zapfenanordnung nach Anspruch 7 oder 9, wobei die seitliche Bewegung der oberen Platte (7) und der Halteplatte (8) durch elastische Lager (7a, 8a) ermöglicht wird.

11. Zapfenanordnung nach Anspruch 1, wobei das obere Ende des Hebezapfens (1) weiterhin einen Zwischenraum aufweist, der dazu eingerichtet ist, eine Rollkugel (14) aufzunehmen.

12. Zapfenanordnung nach Anspruch 11, wobei die Rollkugel (14) von einem Kugellager (13) gehalten wird.

13. Zapfenanordnung nach Anspruch 11 oder 12, welche weiterhin einen Haltering (12) aufweist, der den Zwischenraum abdeckt und verhindert, dass der Hebezapfen durch die Rollenführung fällt.

## Revendications

1. Ensemble broche pour lever et supporter des substrats comprenant :
- une broche (1) de levage ayant des extrémités supérieure et inférieure ;
- l'extrémité supérieure étant conçue pour recevoir et supporter un substrat (4) ;
- l'extrémité inférieure étant conçue pour être actionnée par un système élévateur (3a) ;
- la broche (1) de levage étant soutenue en mouvement par un guide,
dans laquelle ledit guide comprend un patin (2) équipé de galets pour réduire la friction du mouvement de la broche dans un axe vertical.

2. Ensemble broche selon la revendication 1, dans lequel le patin équipé de galets comprend six galets (6) aménagés dans une douille (5).

3. Ensemble broche selon la revendication 1 ou la revendication 2, dans lequel le patin (2) équipé de galets est monté sur une partie basse (2a) d'un réacteur.

4. Ensemble broche selon les revendications 1 à 3, dans lequel le patin (2) équipé de galets comprend des galets (6) fabriqués dans un matériau permettant une faible usure et une faible friction.

5. Ensemble broche selon la revendication 2, dans lequel le patin (2) équipé de galets et la douille sont fabriqués avec le même matériau.

6. Ensemble broche selon la revendication 1, dans lequel l'extrémité inférieure de la broche (1) de levage est, au moins durant l'opération de levage, en contact avec un système (3a) élévateur via une plaque (3) de semelle.

7. Ensemble broche selon la revendication 6, dans lequel la plaque (3) de semelle comprend une plaque supérieure (7) pouvant être déplacée latéralement par rapport audit système élévateur (3a).

8. Ensemble broche selon la revendication 6 ou la revendication 7, dans lequel la plaque de semelle (3) comprend en outre une plaque (8) à billes, des billes (9) étant disposées au-delà de la plaque supérieure (7).

9. Ensemble broche selon la revendication 8, dans lequel la plaque (8) à billes peut être déplacée latéralement par rapport audit système élévateur.

10. Ensemble broche selon la revendication 7 ou la revendication 9, dans lequel le mouvement latéral de la plaque supérieure (7) et de la plaque (8) de maintien est facilité par des paliers élastiques (7a, 8a).

11. Ensemble broche selon la revendication 1, dans lequel l'extrémité supérieure de la broche (1) de levage comprend en outre un espacement étant conçu pour maintenir une bille de (14) roulement.

12. Ensemble broche selon la revendication 11, dans lequel la bille (14) de roulement est supportée par un roulement (13) à billes.

13. Ensemble broche selon la revendication 11 ou la revendication 12, comprenant en outre une bague (12) de retenue couvrant partiellement l'espacement et empêchant la broche de levage de tomber à travers le patin équipé de galets.
